# EUROPEAN PATENT APPLICATION

(11) **EP 1 672 102 A1**
(43) Date of publication of application: **21.06.2006**
(21) Application number: 04771223.7
(22) Date of filing: 29.07.2004
(51) Int. Cl.: C30B 33/10, C30B 29/30, H01L 21/306, C25F 3/02

(54) **FERROELECTRIC THIN-FILM PRODUCTION METHOD, VOLTAGE-APPLICATION ETCHING APPARATUS, FERROELECTRIC CRYSTAL THIN-FILM SUBSTRATE, AND FERROELECTRIC CRYSTAL WAFER**

(30) Priority: 21.08.2003 JP 2003208221
(71) Applicant: Cho, Yasuo, Sendai-shi, Miyagi 980-0813 (JP); Pioneer Corporation, Tokyo 153-8654 (JP)
(72) Inventor: Cho, Yasuo, Sendai-shi, Miyagi 9800813 (JP); Onoe, A., c/o Pioneer Corp., Sougou Kenkyusho, Tsurugashima-shi, Saitama 350-2288 (JP)
(74) Representative: Viering, Jentschura & Partner
(86) International application number: PCT/JP2004/011188
(87) International publication number: WO 2005/019508

(57) **Abstract**

A ferroelectric thin-film production method produces a ferroelectric crystal thin film by using a ferroelectric crystal having first and second surfaces opposed to each other and having an etching rate of the first surface greater than that of the second surface and etching the first surface of the ferroelectric crystal. While etching, a predetermined voltage is applied to the ferroelectric crystal. When the etching progresses and the thickness of the ferroelectric crystal reaches a target value, the direction of polarization of the ferroelectric crystal are inverted and the progress of the etching automatically stops. Consequently, a ferroelectric crystal thin film extremely thin and uniform in thickness over a wide area can be produced.

## Description

### Technical Field

The present invention relates to a ferroelectric thin-film production method, a voltage-application etching apparatus used in the ferroelectric thin-film production method, and a ferroelectric crystal thin-film substrate including a thing-film produced in the ferroelectric thin-film production method.

### Background Art

Conventionally, as a high-density, large-capacity and randomly accessible recording / reproducing apparatus, an optical disc apparatus and a HDD (Hard Disc Drive) apparatus are known.

In optical recording, data is recorded by using an optical pickup with a laser used as a light source to form a pit in a layer or layers of an organic dye (or pigment) or a phase change material formed on a disc, or the data is reproduced by using the fact that the reflectance of the layer varies with or without the pit. Alternatively, the data may be recorded or reproduced by using a magneto optical effect. However, the optical pickup is larger than the magnetic head of the HDD, which is inappropriate for high-speed reading. Moreover, the size of the pit is defined by a light diffraction limit, so that it is considered that a recording density is limited to about 50G bit/inch².

Moreover, in the longitudinal recording of magnetic recording, as represented by the HDD, a magnetic resistance (MR) head has been practically used, recently, by using giant magnetic resistance (GMR). Furthermore, its recording density is expected to be larger than that of the optical disc by using perpendicular magnetic recording. However, because of thermal fluctuation of magnetic record information and the presence of a Bloch wall in a portion in which a code or sign is reversed or changed, and even if patterned media are used in view of the above fact, the recording density is limited to 1 T bit/inch².

On the other hand, recently, the inventors of the present invention has proposed a technology of a recording / reproducing apparatus using SNDM (Scanning Nonlinear Dielectric Microscopy) for nanoscale analysis of a dielectric recording medium. In the SNDM, it is possible to increase resolution related to measurement to sub-nanometer, by using an electrically conductive cantilever (or probe) having a small probe on its tip, which is used for atomic force microscopy (AFM) or the like. Recently, a super high-density recording / reproducing apparatus has been developed, wherein the apparatus records data into a recording medium having a recording layer made of a ferroelectric material by using the technology of SNDM (Japanese Patent Application Laying Open NO. 2003-085969).

### Disclosure of Invention

By the way, in the super high-density recording / reproducing apparatus, polarization is locally reversed by the application of a voltage from the cantilever to the ferroelectric recording medium, and this polarization reverse is used as record information. In the recording operation at this time, if a coercive electric field of the ferroelectric material of the recording medium is Ec and a thickness of the ferroelectric material is d, a voltage V which satisfies a condition of Ec≦V/d is applied to the ferroelectric material, which allows the record information to be recorded by the polarization reverse. Therefore, as the thickness d of the ferroelectric material is smaller, an applied voltage for the recording operation can be lowered more.

Thus, in order to realize the lower voltage, it is desirable that the thickness d of the ferroelectric material has a thickness of several tens nanometers, for example. Moreover, in order to produce the ferroelectric recording medium, it is preferable to form a wafer in which an electrode and the ferroelectric material and the like are laminated on the substrate, and to cut the wafer. In this case, in the wafer condition, it is necessary to uniform a thickness of the ferroelectric material, with the several tens nanometers. This is because there is such a disadvantage that if the thickness of the ferroelectric material of the ferroelectric recording medium which is produced is not uniform, it is impossible to standardize the applied voltage which is applied to record the information, and it is difficult to produce the super high-density recording / reproducing apparatus.

However, in a sol-gel method, a spatter method, and the like which are conventionally used for the formation of a thin film, there is such a technical problem that it is difficult or impossible to prepare a uniform thin film related to the ferroelectric material. More specifically, even if flattening can be realized on the micrometer order, not negligible unevenness or variation of the thickness may be caused on the nanometer order. In other words, even if it is possible to form the ferroelectric material suitable for the application of a Fe-RAM (Ferroelectric Random Access Memory) or the like, which is practically used on the micrometer order, there is such a technical problem that it is difficult or impossible to form the ferroelectric material suitable for the application of the super high-density recording medium which uses the ferroelectric material having a thickness on the nanometer order.

As opposed to this, from the study performed by the inventors of the present invention, a thin-film formation method has been developed in which mechanical polishing, performed by a CMP (Chemical Mechanical Polishing) method, and dry etching are combined to make a thin film of a ferroelectric single crystal. According to the thin-film formation method, it is found out that the ferroelectric substance can be thinned to the order of 100nm, and that uniform recording can be performed even at 1.5T bit/inch². However, in order to uniform the thickness distribution of the entire wafer having the radius of 3 inch on the order of nanometer by the thin-film formation method, for example, strict process management is required, and there is such a technical problem that the cost greatly increases.

In order to solve the above-exemplified problems, it is therefore an object of the present invention to provide a ferroelectric thin-film production method which allows efficient production of a ferroelectric material having a uniform thickness distribution, with a thickness of the order of sub-micrometers to several tens nanometers, for example, a voltage-application etching apparatus used in the ferroelectric thin-film production method, and a ferroelectric crystal thin-film substrate including a thing-film produced in the ferroelectric thin-film production method.

The present invention will be discussed hereinafter.

A ferroelectric thin-film production method of the present invention is provided with: an etching process of dipping one surface in an etching solution to thereby etch the one surface, with respect to a ferroelectric crystal which has the one surface and another surface that face each other and in which an etching rate of the one surface is greater than an etching rate of the another surface in such a condition that polarization directions are oriented in one direction; and a voltage applying process of applying a predetermined voltage between the one surface and the another surface.

According to the ferroelectric thin-film production method of the present invention, it is possible to produce the thin film of a ferroelectric substance which has a uniform thickness and which has flatness on the nanometer order. Incidentally, the "ferroelectric substance" in the present invention is a dielectric substance which changes the direction of spontaneous polarization by applying a voltage and which maintains the polarization direction even if the application of the voltage is subsequently stopped.

In particular, in the ferroelectric substance used in the present invention, the etching rate of the one surface is greater than the etching rate of another surface. In other words, the one surface has such a characteristic that the one surface is etched easier than another surface. This difference in the etching rate is determined, depending on the direction of spontaneous polarization owned by the ferroelectric crystal. The case where z-cut LiTaO₃ is used as the ferroelectric crystal is discussed. In this case, if the ferroelectric crystal has the polarization directions which are perpendicular to the one surface and another surface and which are aligned throughout the entire ferroelectric crystal, or if the ferroelectric crystal has a similar structure to the above structure, a plus surface located on the plus side of the polarization direction is more difficult to be etched than a minus surface located on the minus side of the polarization direction. In this case, the minus surface is the one surface, and the plus surface is another surface. Incidentally, whether or not the ferroelectric crystal has such a structure or characteristic varies depending on the type of the ferroelectric crystal. In the present invention, it is preferable to select and use the ferroelectric crystal having the above-mentioned structure or characteristic.

Then, in the etching process, the one surface is etched by dipping the one surface of the ferroelectric crystal in the etching solution. At this time, it is preferable to take some measures so that a surface not to be etched (e.g. another portion other than the one surface) is not exposed to the etching solution, in the etching process.

Then, while the etching process is performed, the voltage applying process is performed. In the voltage applying process, a predetermined size of voltage is applied between the one surface and another surface of the ferroelectric crystal. In this case, preferably, the one surface which is exposed to the etching solution and another surface which is not to be exposed to the etching solution are electrically insulated.

Here, the ferroelectric crystal has spontaneous polarization and has such a characteristic that the polarization direction of the crystal is reversed if an electric field having the opposite direction to the spontaneous polarization is applied from the exterior and the extent of the electric filed exceeds a constant value. The extent of a voltage which causes the reverse of the polarization direction is peculiar to a material, and an electric filed generated in the material by the voltage is referred to as a coercive electric field. The extent of the voltage which is applied to the ferroelectric crystal to cause the reverse of the polarization direction varies depending on the thickness of the ferroelectric crystal. In the present invention, for convenience of explanation, it is assumed that the coercive electric field of the ferroelectric crystal is "Ec", and that the voltage applied when the polarization direction of the ferroelectric crystal is actually reversed is a "polarization reverse voltage e", while the explanation proceeds. For example, the coercive electric field Ec of LiTaO₃ (lithium tantalate) described later is about 22kV/mm. If the thickness of the ferroelectric crystal is 100nm, the polarization reverse voltage e is about 2.2V

In the voltage applying process, if a thickness to be desirably set on the ferroelectric crystal is a desired or targeted thickness d, a predetermined voltage V applied to the ferroelectric crystal is preferably set to be V=Ec × d. The electric field formed in the ferroelectric crystal by the application of the voltage V is substantially equal to the electric field formed in the ferroelectric crystal by the application of the polarization reverse voltage e when the ferroelectric crystal has the desired thickness d. For example, if the desired thickness of the above-mentioned LiTaO₃ is desirably set to 100nm, the predetermined voltage V is set to 2.2V (i.e. 22[kV/mm] × 100[nm]).

If the etching progresses in the etching process, the ferroelectric crystal melts from the one surface side, and the thickness is gradually reduced. Along with this, the polarization reverse voltage e of the ferroelectric crystal is gradually reduced. Then, when the thickness of the ferroelectric crystal reaches the desired thickness d, the polarization reverse voltage e of the ferroelectric crystal is substantially equal to the voltage V applied at that time. As a result, when the thickness of the ferroelectric crystal reaches the desired thickness d, the polarization direction of the ferroelectric crystal is reversed. If the polarization direction of the ferroelectric crystal is reversed, the etching rate of the one surface is greatly reduced, so that the progress of the etching is substantially stopped. Therefore, if a uniform electric field is formed throughout the one surface of the ferroelectric crystal by the predetermined voltage V which is applied to the ferroelectric crystal, the thickness of the ferroelectric crystal is the thickness d which is uniform throughout the entire surface. Incidentally, the application of an electric field to the etching surface (i.e. the one surface) of the substrate is performed, with the ionized etching solution used as one electrode. In this case, the etching solution is spread throughout the one surface, so that it is possible to uniformly perform the application of the electric field to the entire one surface during the etching.

As described above, according to the ferroelectric thin-film production method of the present invention, the thickness of the ferroelectric crystal is set to the desired thickness by using such a characteristic that the etching rate of the one surface is greatly reduced due to the reverse of the polarization direction. Thus, it is possible to form the thin film of the ferroelectric crystal which has a thickness on the submicrometer order or several tens nanometer order; for example, less than 1 *µ* m. Moreover, even if the one surface of the ferroelectric crystal has a large area size (e.g. about the same area size as that of a wafer surface), it is possible to uniform the thickness throughout the entire surface.

In one aspect of the ferroelectric thin-film production method of the present invention, the ferroelectric crystal is a single crystal wafer of a ferroelectric substance.

According to this aspect, it is possible to produce the ferroelectric single crystal wafer which has a thickness on the submicrometer order or several tens nanometer order and which has a uniform thickness throughout a large area, as described above. For example, the entire surface of the wafer or a portion other than the periphery portion thereof can be made uniform in thickness. For example, if a ferroelectric recording medium is produced, the thinned ferroelectric crystal wafer is used. By this, it is possible to massively produce the ferroelectric recording medium having the uniform thickness, and mass-produce the ferroelectric recording medium.

In another aspect of the ferroelectric thin-film production method of the present invention, the ferroelectric crystal includes at least one of LiNbₓTa₁₋ₓO₃ (0≦x≦1), M: LiNbₓTa₁₋ₓO₃ (0≦x≦1, M is a doping material), and K₃Li₂₋ₓ(Nb_{1-y}Ta_{y}) ₅₊ₓO₁₅₊₂ₓ.

It is confirmed that there is a big difference in the etching rate due to a difference in the polarization direction. By using the ferroelectric crystal, it is possible to realize the above-mentioned ferroelectric thin-film production method in which the etching rate is changed by the reverse of the polarization direction, and it is possible to derive an effect achieved by the production method. In other words, by using the ferroelectric crystal, it is possible to produce the ferroelectric crystal thin film which has a thickness on the submicrometer order or several tens nanometer order and which has a uniform thickness in a large area, inexpensively, certainly, and highly accurately.

Incidentally, as the material M doped to LiNbₓTa₁₋ₓO₃, for example, MgO, ZnO, or the like can be used. Other materials can be doped to LiNbₓTa₁₋ₓO₃, and can receive the above-mentioned various benefits.

In another aspect of the ferroelectric thin-film production method of the present invention, the voltage which is applied to the ferroelectric crystal in the voltage applying process is a direct current voltage.

According to this aspect, the etching is performed while a direct current (DC) voltage having a predetermined size of voltage is applied. By this, it is possible to produce the ferroelectric crystal thin film which has a thickness on the submicrometer order or several tens nanometer order and which has a uniform thickness in a large area, as described above.

In another aspect of the ferroelectric thin-film production method of the present invention, the voltage which is applied to the ferroelectric crystal in the voltage applying process is a pulse voltage.

For example, the continuous application of a voltage may cause an electrochemical effect in the etching solution. This phenomenon likely increases the etching rate of another surface in which the etching rate is to be low originally (or the one surface after the polarization is reversed). As opposed to this, according to this aspect, it is possible to etch the one surface (the one surface without the polarization reversed), appropriately, without causing the electrochemical effect during the etching.

In another aspect of the ferroelectric thin-film production method of the present invention, the desired thickness d is less than 1 *µ* m.

According to this aspect, it is possible to produce or mass-produce the thin film having a uniform thickness which is less than 1 *µ* m. If the etching process and the voltage applying process are performed to the ferroelectric crystal wafer, it is possible to produce the ferroelectric crystal wafer having a uniform thickness which is less than 1 *µ* m.

In another aspect of the ferroelectric thin-film production method of the present invention, the etching solution includes hydrofluoric acid.

According to this aspect, it is possible to appropriately etch even a material which is relatively difficult to be etched like the ferroelectric crystal.

In another aspect of the ferroelectric thin-film production method of the present invention, the etching solution has conductivity.

According to this aspect, in applying a voltage between the one surface and another surface, the etching solution can be used as a medium to apply a voltage. For example, if a voltage is applied to the etching solution, it is possible to uniformly apply a voltage to the entire one surface of the ferroelectric crystal which is exposed to the etching solution. Therefore, in the etching process and the voltage applying process, it is possible to uniform the thickness of the ferroelectric crystal and form a flat surface.

In another aspect of the ferroelectric thin-film production method of the present invention, the etching process includes a heating process of heating the etching solution.

According to this aspect, it is possible to promote the progress of the etching. Therefore, it is possible to produce the ferroelectric crystal thin film which has a thickness on the submicrometer order or several tens nanometer order and which has a uniform thickness in a large area, in a shorter time.

In this case, the etching process (or the heating process) may include a temperature measuring process of measuring the temperature of the etching process in order to control the temperature of the etching solution.

Moreover, the etching process may include a refluxing process of refluxing the evaporated etching solution as the etching solution again, in order to prevent the reduction of the etching solution caused by the evaporation of the etching solution with heat.

In another aspect of the ferroelectric thin-film production method of the present invention, the etching process includes a stirring process of stirring the etching solution.

According to this aspect, particularly during the progress of the etching, it is possible to keep the concentration of the etching solution uniform, and it is possible to preferably prevent the dispersion or variation of the progress rate of the etching due to a difference in the position on the one surface. Therefore, it is possible to uniform the progress of the etching.

In another aspect of the ferroelectric thin-film production method of the present invention, the etching process includes a filtrating process of filtrating the etching solution.

According to this aspect, it is possible to keep the high purity of the etching solution, by filtrating and removing the impurities in the etching solution. Therefore, it is possible to prevent the reduction of the progress rate of the etching and preferably prevent the dispersion or variation of the etching which is influenced by the impurities.

In another aspect of the ferroelectric thin-film production method of the present invention, the ferroelectric thin-film production method is provided with: an electrode forming process of forming an electrode in a film shape on the another surface; a substrate connecting process of connecting the electrode and a substrate; and a polishing process of polishing the one surface of the ferroelectric crystal, and the etching process and the voltage applying process are performed after the electrode forming process, the substrate connecting process and the polishing process.

According to this aspect, in the electrode forming process, an electrode is formed on another surface of the ferroelectric crystal which is a raw material. The electrode formed in this manner can be used as an electrode in applying a voltage between the one surface and another surface in the above-mentioned etching process. Moreover, if the ferroelectric crystal thin film produced in the production method of the present invention is used as a recording medium, the electrode formed here can be also used as an electrode in applying an electric field, to record the information into the recording medium or the like (which will be discussed in detail later).

Then, in the substrate connecting process, the electrode and the substrate are connected. In this connection, as described later, an adhesive may be used to connect, or anodic bonding is used to connect, or another method may be used. In other words, a method is no object if it can appropriately connect the electrode and the substrate. However, it is preferable to select a connecting method which provides excellently close connection, which does not cause unnecessary stress by the connection, which does not cause a deforming force which impairs the flatness of the surface of the ferroelectric crystal thin film, and which hardly causes deformation with time and deformation by temperature changes, in order to maintain the flatness of the surface of the ferroelectric crystal thin film formed on the electrode.

For the substrate, a silicon substrate, a ferroelectric substance (e.g. a ferroelectric substance made of the same material as that of the ferroelectric crystal which is used as the raw material in the ferroelectric thin-film production method of the present invention), a glass substrate, or the like are used, for example. Alternatively, any material other than these having strength as the support of the ferroelectric crystal, as described later, can be used as the substrate. By this, it is possible to used the substrate as the support of the ferroelectric crystal whose strength is reduced by thinning it. Therefore, the substrate preferably has a thickness to some degree, as compared to the ferroelectric crystal. For example, if the thickness of the ferroelectric crystal is about 100nm, the thickness of the substrate is preferably about 0.5mm.

Then, in the polishing process, the one surface side of the ferroelectric crystal on which the electrode and the substrate are formed is polished and thinned to an appropriate thickness (e.g. 10 *µ* m). The polishing method may be a method of mechanically polishing by using a surface grinding machine which uses a rotating whetstone, a rotating disc-shaped board, or the like, or may be so-called chemical polishing, such as simple etching. The ferroelectric crystal is roughly thinned in the polishing process, and then thinned highly accurately in the etching process and the voltage applying process, by which the entire thinning can be performed efficiently, and the operation can be shortened.

In another aspect of the ferroelectric thin-film production method provided with the substrate connecting process, the substrate has a difference in a coefficient of thermal expansion of 50% or less, as compared to the ferroelectric crystal.

In general, the volume (or area size) of various members, such as the substrate and the ferroelectric crystal, is expanded or contracted caused by temperature changes. Therefore, even if the substrate and the ferroelectric crystal are connected, the expansion or the like due to the temperature changes possibly causes the exfoliation of the connecting surface between the substrate and the ferroelectric crystal, or the damage of the substrate or the ferroelectric crystal, or the like. However, according to this aspect, even if the substrate and the ferroelectric crystal are both expanded (or contracted) due to the temperature changes, that does not cause a big difference in the extent of their expansion or the like. Therefore, it is possible to prevent the damage, or the exfoliation or the like of the connecting surface, as described above, and it is possible to produce the ferroelectric thin film which is resistant to the temperature changes, relatively easily. This is a great advantage in the point that it is possible to realize the ferroelectric recording medium which can perform stable recording and reproduction operations, regardless of the temperature changes caused by the application of a voltage in the case where the recording and the reproduction operations are performed by the application of the voltage, as described later, for example.

More preferably, a coefficient of thermal expansion of the substrate and a coefficient of thermal expansion of the ferroelectric crystal have the same or substantially the same value. By this, it is possible to effectively prevent the damage, or the exfoliation of the connecting surface, as described above, caused by the temperature changes upon the use of the ferroelectric thin film.

In another aspect of the ferroelectric thin-film production method provided with the substrate connecting process, the substrate includes a same material as that of the ferroelectric crystal.

According to this aspect, regardless of the temperature changes, the extent of the expansion (or contraction) of the substrate and the ferroelectric crystal is the same or substantially the same, so that it is possible to prevent the damage, or the exfoliation of the connecting surface, more effectively.

As described above, in another aspect of the ferroelectric thin-film production method provided with the substrate connecting process, it may be constructed such that the substrate is a glass substrate, and that the electrode and the substrate are directly connected by anodic bonding, in the substrate connecting process.

By such construction, the anodic bonding is performed by applying a voltage of about several tens to several kV, between glass (i.e. the substrate herein) including alkali metal ions and metal or semiconductor (i.e. the electrode herein), at a temperature of about 200 to 400 degrees Celsius in which the thermal diffusion of alkali metal ions occurs, with the metal side as an anode. Therefore, it is possible to directly and firmly connect the electrode and the substrate, without an adhesive or the like, for example. Moreover, it is possible to realize uniform adhesive strength on the adhesive surface and closely connect or bond the electrode and the substrate. At this time, the substrate is a glass substrate, and it is preferably a glass substrate including cations, such as sodium ions and lithium ions (i.e. alkali metal ions), from the viewpoint that the anodic bonding is realized.

In another aspect of the ferroelectric thin-film production method provided with the substrate connecting process, it may be constructed such that a glass film is provided between the electrode and the substrate, and that the electrode and the substrate are connected by anodic bonding, in the substrate connecting process.

By such construction, even in the case of the substrate which does not include glass, it is possible to connect the substrate and the electrode, appropriately and firmly, by the anodic bonding, by using the glass film. Incidentally, the glass film is preferably formed on the electrode before the anodic bonding is performed. Then, by applying a voltage between the glass film and the substrate, the thermal diffusion of cations in the glass film occurs, to thereby connect the glass film and the substrate. As a result, the glass film and the substrate are firmly connected.

In another aspect of the ferroelectric thin-film production method of the present invention, the electrode and the substrate are connected by providing an adhesive layer therebetween, in the substrate connecting process.

According to this aspect, it is possible to connect the electrode and the substrate by using the adhesive layer, relatively easily and at low cost. As the adhesive layer, an adhesive, such as epoxy resins, may be sued, or a brazing material or the like may be used, as described later.

In an aspect of the ferroelectric thin-film production method in which the adhesive layer is provided in the substrate connecting process, as described above, a conductive base layer which is highly adhesive is provided at least one of between the adhesive layer and the electrode, and between the adhesive layer and the substrate, in the substrate connecting process.

By such construction, even if the adhesive strength of the adhesive layer is not strong or firm, it is possible to connect the substrate and the electrode, firmly. In other words, even if the brazing material is used as the adhesive layer, for example, if there is provided the conductive base layer including titan and chromium which are highly adhesive, it is possible to make a firm connection by the adhesion of the conductive base layer.

Incidentally, the electrode at this time is preferably the conductive base layer which is highly adhesive.

In another aspect of the ferroelectric thin-film production method of the present invention, a smoothing process is performed to the one surface after the one surface is polished.

According to this aspect, it is possible to smooth very small unevenness cause by the mechanical polishing in the polishing process, and improve an etching accuracy in the subsequent etching process. In the smoothing process herein, for example, CMP (Chemical Mechanical Polishing) or the like may be used.

A voltage-application etching apparatus of the present invention is a voltage-application etching apparatus used in the etching process and the voltage applying process in the above-mentioned ferroelectric thin-film production method of the present invention (including its various aspects), the voltage-application etching apparatus provided with: a container to dip the one surface in the etching solution; a sealing device for sealing a portion other than the one surface from the etching solution; a power supply for applying the predetermined voltage between the one surface and the another surface; a first connecting device for electrically connecting one output terminal of the power supply with the one surface; and a second connecting device for electrically connecting another output terminal of the power supply with the another surface.

According to the voltage-application etching apparatus of the present invention, it is possible to appropriately perform the etching process and the voltage applying process in the above-mentioned ferroelectric thin-film production method of the present invention.

Specifically, the ferroelectric crystal (the one surface thereof is dipped in the etching solution. The etching solution is preferably stored in (or fills) the container. Then, the predetermined voltage is applied between the one surface and another surface of the ferroelectric crystal from the power supply. At this time, a voltage is supplied to the one surface by the first connecting device. The first connecting device may be constructed to dip the electrode in the etching solution having conductivity, as described later, for example. According to this structure, a voltage is applied to the one surface of the ferroelectric crystal through the etching solution. If the one surface of the ferroelectric crystal is exposed to the etching solution throughout the entire surface, a voltage is uniformly applied to the entire one surface of the ferroelectric crystal. As a result, it is possible to form a uniform electric field in the ferroelectric crystal. By this, it is possible to produce the ferroelectric crystal thin film having a uniform thickness.

On the other hand, a voltage is supplied to another surface by the second connecting device. As the second connecting device, for example, the electrode formed on the above-mentioned ferroelectric crystal (on another surface side) may be used. Specifically, the electrode and the power supply may be connected with a lead wire or the like.

After that, as described above, the etching progresses until the ferroelectric crystal has the desired thickness. The polarization direction is reversed when the strength of the electric field caused by the applied voltage exceeds the coercive electric field of the ferroelectric crystal, and the progress of the etching is practically stopped.

In particular, the etching solution is not exposed to a portion other than the one surface of the ferroelectric crystal, by virtue of the sealing device. Therefore, it is possible to appropriately etch the one surface to be originally etched. The sealing device may be a packing including an O ring or the like, as described later, or may be a sealing can, a sealing film or the like which covers the portion other than the one surface, for example.

As described above, according to the voltage-application etching apparatus of the present invention, it is possible to appropriately etch another surface of the ferroelectric crystal while a voltage is applied. Therefore, if the predetermined voltage is applied on the basis of the desired thickness of the ferroelectric crystal and the coercive electric field of the ferroelectric crystal, as described above, it is possible to produce the ferroelectric crystal having the desired thickness. In particular, it is possible to realize the thickness on the submicrometer order or several tens nanometer order, and it is possible to produce the ferroelectric thin film having a uniform thickness in a large area, relatively easily.

Incidentally, in response to the various aspects of the etching process and the voltage applying process of the above-mentioned ferroelectric thin-film production method of the present invention, the voltage-application etching apparatus of the present invention can adopt various aspects.

In one aspect of the voltage-application etching apparatus of the present invention, the sealing device is an acid-resistant O ring which is pressed onto a periphery portion on the one surface or an outer edge of the one surface.

According to this aspect, it is possible to relatively easily fix another surface not to be exposed to the etching solution, selectively.

In another aspect of the voltage-application etching apparatus of the present invention, it is further provided with a heating device for heating the etching solution.

According to this aspect, it is possible to promote the progress of the etching. Therefore, it is possible to produce the thin film having the ferroelectric crystal with the desired thickness in a shorter time.

In this case, the etching device (or the heating device) may include a temperature measuring device for measuring the temperature of the etching process in order to control the temperature of the etching solution.

Moreover, the etching device may include a refluxing device for refluxing the evaporated etching solution as the etching solution again, in order to prevent the reduction of the etching solution caused by the evaporation of the etching solution with heat.

In another aspect of the voltage-application etching apparatus of the present invention, it is further provided with a stirring device for stirring the etching solution.

According to this aspect, particularly during the progress of the etching, it is possible to keep the concentration of the etching solution uniform, and it is possible to preferably prevent the dispersion or variation of the progress rate of the etching due to a difference in the position on the one surface. Therefore, it is possible to uniform the progress of the etching.

In another aspect of the voltage-application etching apparatus of the present invention, it is further provided with a filtrating device for filtrating the etching solution.

According to this aspect, it is possible to keep the high purity of the etching solution, by filtrating and removing the impurities in the etching solution. Therefore, it is possible to prevent the reduction of the progress rate of the etching and preferably prevent the dispersion or variation of the etching which is influenced by the impurities.

A ferroelectric crystal thin-film substrate of the present invention is provided with: a substrate; an electrode formed on the substrate; and a ferroelectric crystal which is formed on the electrode and which is less than 1 *µ* m in thickness, wherein an area size of an entire surface of the substrate is equal to or greater than 10mm².

According to the ferroelectric crystal thin-film substrate of the present invention, the ferroelectric crystal thin film is 1µm in thickness and has a uniform thickness in a large area of 10mm² or more. Thus, it is possible to use the ferroelectric crystal thin film as the material of a ferroelectric recording medium, and by this, it is possible to mass-produce the ferroelectric recording medium.

Here, the ferroelectric recording medium has a recording layer made of the ferroelectric crystal thin film. Then, information is recorded by applying a voltage large enough to form an electric field which exceeds the coercive electric field to the ferroelectric crystal thin film to thereby reverse the polarization direction of the ferroelectric crystal thin film. Therefore, if the ferroelectric crystal thin film is thin, it is possible to reduce a voltage required for the reverse of the polarization (i.e. required for the information recording). In addition, if the thickness of the ferroelectric crystal thin film is uniform, it is possible to make the voltage required for the information recording constant. If the voltage required for the information recording can be reduced, it is possible to reduce the power consumption of a recording apparatus for recording the information into the ferroelectric recording medium. Moreover, if the voltage required for the information recording can be made constant, it is possible to unify an applied voltage for the information recording, on the recording apparatus. If the applied voltage can be unified, it is possible to standardize the applied voltage, for example, and it is possible to realize the commercialization of the recording apparatus. Moreover, by using the above-mentioned ferroelectric recording medium, the polarization can be reversed in a very small size on the nanometer order. Thus, it is possible to realize a super high density recording / reproducing apparatus with SNDM used as a reproduction method.

Incidentally, the ferroelectric crystal thin-film substrate of the present invention is preferably produced in the above-mentioned ferroelectric thin-film production method of the present invention (including its various aspects).

In one aspect of the ferroelectric crystal thin-film substrate of the present invention, the substrate is a glass substrate, and the substrate and the electrode are directly connected by anodic bonding.

According to this aspect, it is possible to realize the ferroelectric crystal thin-film substrate in which the substrate and the electrode are connected, uniformly, closely, and firmly. Moreover, as explained in the above-mentioned ferroelectric thin-film production method of the present invention, a difference in the coefficient of thermal expansion between the substrate and the ferroelectric crystal thin film is preferably 50% or less. By this, it is possible to prevent the damage, the exfoliation of the connecting surface, or the like. Moreover, the substrate and the ferroelectric crystal thin film may include the same material.

In another aspect of the ferroelectric crystal thin-film substrate of the present invention, in the ferroelectric crystal, polarization directions are perpendicular to the surface and oriented in a same direction.

According to this aspect, in the case where the ferroelectric crystal thin-film substrate of the present invention is used for the ferroelectric recording medium, it is unnecessary to separately perform a format process to orient the polarization directions in the same direction, or the like.

Specifically discussing, in the case where predetermined information is recorded into the ferroelectric recording medium, the following process is performed; namely, the polarization direction is reversed when a data bit corresponding to the information is "1", and the current polarization direction is maintained when the data bit is "0". In order to realize this process, the polarization directions of the ferroelectric crystal thin film of the recording medium are preferably oriented in the same direction at an initial stage before the information is recorded. According to the present invention, the polarization directions are oriented in the same direction in advance, so that it is possible to satisfy the requirement.

Moreover, the information recording into the ferroelectric recording medium is performed by a change in the polarization direction. For example, in order to record binary information by the change in the polarization direction, the domain structure of a recording surface is preferably a 180 degree domain structure. According to the present invention, the polarization axis of the ferroelectric crystal thin film is perpendicular to the one surface of the ferroelectric crystal thin film. Thus, if the one surface is the recording surface, the domain structure of the recording surface is the 180 degree domain structure, so that it is possible to satisfy the requirement.

As explained above, according to the ferroelectric thin-film production method of the present invention, it is provided with: the etching process; and the voltage applying process. Therefore, it is possible to produce the thin film of the ferroelectric crystal having a uniform thickness on the submicrometer order or several tens nanometer order, relatively easily and efficiently, by appropriately adjusting or controlling a voltage which is applied upon the etching. Moreover, even in the case of the ferroelectric crystal having a large area size, such as a wafer, it is possible to produce the thin film of the ferroelectric crystal having a uniform thickness throughout the entire large area, by performing the etching while applying a predetermined voltage. Then, by the production method of the present invention, it is possible to mass-produce the ferroelectric recording medium by using a ferroelectric crystal wafer which is extremely thin and which has a flat surface.

Moreover, according to the voltage-application etching apparatus of the present invention, it is provided with: the container; the sealing device; the power supply; the first connecting device; and the second connecting device. Therefore, it is possible to appropriately perform the etching process and the voltage applying process in the above-mentioned ferroelectric thin-film production method of the present invention.

Furthermore, according to the ferroelectric crystal thin-film substrate of the present invention, it is provided with: the substrate; the power supply; and the ferroelectric crystal. Therefore, it is possible to record the information at a relatively low voltage. Moreover, since the dielectric substance as being the recording layer has a uniform thickness, it is possible to prevent the variation of the applied voltage necessary upon the recording, and it is possible to standardize the applied voltage. By this, it is possible to use the ferroelectric crystal thin-film substrate as a recording medium to realize super high density ferroelectric recording.

### Brief Description of Drawings

FIG. 1 is a flowchart showing an entire producing process of an embodiment according to the ferroelectric thin-film production method of the present invention;
FIG. 2 is a cross-sectional view conceptually showing a ferroelectric crystal used in the embodiment according to the ferroelectric thin-film production method of the present invention;
FIG. 3 is a cross-sectional view conceptually showing the ferroelectric crystal after an electrode forming process, in the embodiment according to the ferroelectric thin-film production method of the present invention;
FIG. 4 is a cross-sectional view conceptually showing one aspect of substrate connection by a substrate connecting process, in the embodiment according to the ferroelectric thin-film production method of the present invention;
FIG. 5 is a cross-sectional view conceptually showing another aspect of substrate connection by the substrate connecting process, in the embodiment according to the ferroelectric thin-film production method of the present invention;
FIGs. 6 are cross-sectional views conceptually showing another aspect of substrate connection by the substrate connecting process, in the embodiment according to the ferroelectric thin-film production method of the present invention;
FIG. 7 is a cross-sectional view conceptually showing another aspect of substrate connection by the substrate connecting process, in the embodiment according to the ferroelectric thin-film production method of the present invention;
FIG. 8 is a cross-sectional view conceptually showing an aspect of a polishing process, in the embodiment according to the ferroelectric thin-film production method of the present invention;
FIGs. 9 are cross-sectional views conceptually showing the basic structure of a voltage-application etching apparatus used in an etching process, in the embodiment according to the ferroelectric thin-film production method of the present invention;
FIGs. 10 are schematic diagrams conceptually showing the progress of the etching process, in the embodiment according to the ferroelectric thin-film production method of the present invention;
FIG. 11 is a graph showing a pulse voltage applied in the etching process, in the embodiment according to the ferroelectric thin-film production method of the present invention;
FIG. 12 is a perspective view conceptually showing a dielectric recording medium prepared by using the thin film produced by the embodiment according to the ferroelectric thin-film production method of the present invention; and
FIG. 13 is an explanatory diagram conceptually showing a probe portion of a dielectric recording apparatus for recording information into the dielectric recording medium or for reproducing the information.

### Best Mode for Carrying Out the Invention

Hereinafter, the embodiments of the present invention will be explained with reference to the drawings. Incidentally, the ferroelectric thin-film production method explained below is intended to produce a ferroelectric thin film (hereinafter referred to as a "thin film", as occasion demands) having a thickness thin enough to use a dielectric recording medium, for example, mainly from a ferroelectric crystal.

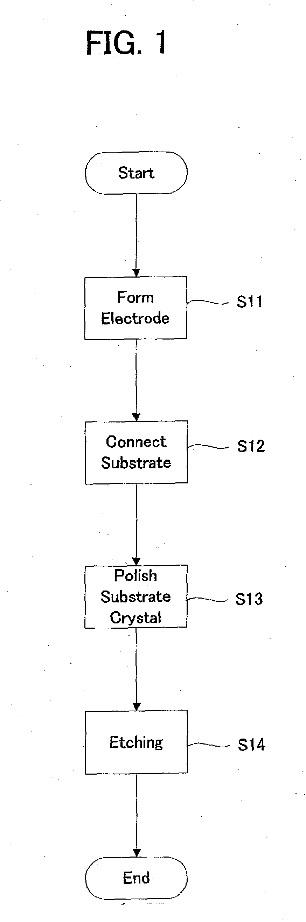

At first, with reference to FIG. 1, an entire producing process related to the ferroelectric thin-film production method in this embodiment will be discussed. FIG. 1 is a flowchart showing the entire producing process of the ferroelectric thin-film production method in the embodiment.

As shown in FIG. 1, the ferroelectric thin-film production method in this embodiment is provided with: an electrode forming process (step S11); a substrate connecting or bonding process (step S12); a polishing process (step S13); and an etching process (step S14).

In the electrode forming process, an electrode is formed on one surface (another surface) of a ferroelectric crystal wafer with a thickness of 400 *µ* m, for example.

In the substrate connecting process, the electrode formed in the step S11 is connected or bonded to a substrate.

In the polishing process, the ferroelectric crystal is mechanically polished to be on the order of 10 *µ* m in thickness, for example.

In the etching process, the ferroelectric crystal is dipped in an etching solution to perform etching. Then, during the etching, a predetermined size of voltage is applied to the ferroelectric crystal. By this, the ferroelectric crystal is thinned to be less than 500nm in thickness, for example.

Particularly in the embodiment, in the etching process in the step S14, by using the change of an etching rate caused by the polarization reverse of the ferroelectric crystal, it is possible to make the ferroelectric crystal be less than 500nm in thickness while keeping it in the wafer condition. Moreover, it is also possible to flatten the etching surface over a wide range. The detail of the etching process will be discussed later.

Hereinafter, each process shown in FIG. 1 will be discussed in more detail.

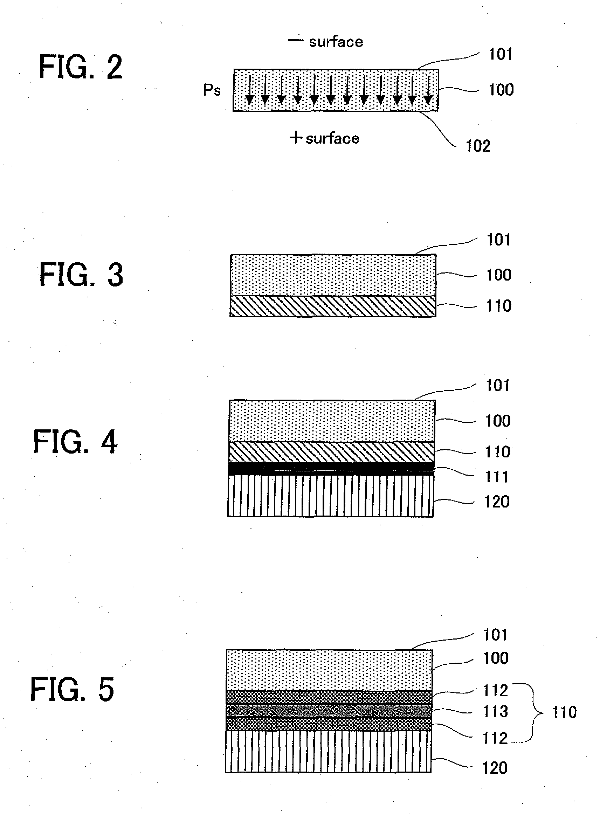

FIG. 2 shows a wafer of a ferroelectric single crystal, which is the raw material of the ferroelectric crystal used in the ferroelectric thin-film production method in the embodiment. As shown in FIG. 2, the wafer of the ferroelectric single crystal (e.g. 100mm in diameter) is used as the raw material of a ferroelectric crystal 100. The ferroelectric crystal 100 has spontaneous polarization Ps, and the direction of the polarization (i.e. orientation) is directed from a surface 101 (one surface) to a surface 102 (another surface). In other words, the same state is realized as such a state that negative charges are generated on the surface 101 side and positive charges are generated on the surface 102 side. Then, in the ferroelectric crystal 100, there is a big difference in the etching rate of the surface 101 and the surface 102, due to the difference of plus (positive) and minus (negative) in the polarization axis direction.

As the ferroelectric crystal 100, there are LiNbₓTa₁₋ₓO₃ (0≦x≦1), M: LiNbₓTa₁₋ₓO₃ (0 ≦ x ≦ 1, M is a doping material, such as MgO and ZnO), K₃Li₂₋ₓ(Nb_{1-y}Ta_{y})₅₊ₓO₁₅₊₂ₓ, and the like. For example, in the above-mentioned LiTaO₃ and LiNbO₃ or the like, the etching rate of the surface 102 (i.e. the surface on the side that positive charges are generated) is smaller than that of the surface 101 (i.e. the surface on the side that negative charges are generated), so that the surface 102 is more difficult to etch than the surface 101.

However, materials used as the ferroelectric crystal 100 are not limited to the above materials, and any materials may be used if having a difference in the etching rate due to a difference in the polarization direction.

Moreover, the ferroelectric crystal 100 preferably maintains uniform crystallinity from the inside of the crystal to the surface (i.e. the surfaces 101 and 102). Then, as shown in FIG. 2, all the polarization axes are preferably perpendicular to the surfaces and face in the same direction. By this, the thin film, produced by the ferroelectric thin-film production method in this embodiment, can be used for a ferroelectric recording medium, relatively easily, as described later.

FIG. 3 shows the "electrode forming process" in FIG. 1. As shown in FIG. 3, in the electrode forming process, a film-shaped electrode 110 is formed on the surface 102 of the ferroelectric crystal 100. Incidentally, the surface 102 on which the electrode 110 is formed is a surface with a low etching rate, due to the polarization direction currently set on the ferroelectric crystal 100.

As the electrode 110, noble metal, such as Au and Pt, a metal material, such as Al, Cr, and Ti, or a conductive oxide, such as LASCO (La_{0.5}Sr_{0.5}CoO₃) and SrRuO₃, is used. The electrode 110 is formed on the surface 102 of the ferroelectric crystal 100 in a sputtering method or a deposition method, or the like. The sputtering method or deposition method can use the respective conventional technologies.

At this time, a surface on which the electrode 110 is formed (i.e. a connecting surface of the electrode 110 and the surface 102) is perpendicular to the polarization axis of the ferroelectric crystal.

Incidentally, the electrode 110 functions as an etching electrode for applying a voltage to the ferroelectric crystal, in the subsequent etching process. Moreover, if the ferroelectric thin-film produced in the production method in this embodiment is used as a ferroelectric recording medium, the electrode 110 is used as an electrode in applying a voltage to the recording medium.

Next, FIG. 4 to FIG. 7 show the "substrate connecting process" in FIG. 1. For example, there are four methods in the method of substrate connection in the substrate connecting process. FIG. 4 to FIG. 7 show four specific examples of the substrate connecting process using the respective four methods.

As shown in FIG. 4, the first specific example of the substrate connecting process is to use an adhesive 111 to connect or bond the electrode 111 and a substrate 120. As the adhesive 111, for example, epoxy resin and acrylate resin or the like may be used. By this, it is possible to bond the electrode 110 and the substrate 120, relatively easily and at low cost.

In this case, as the substrate 120, a silicon substrate, a glass substrate, or a ferroelectric substance made of the same material as or different material from the ferroelectric crystal 100, or the like can be used. The substrate 120 will make the support of the ferroelectric crystal 100, so that the thickness of the substrate 120 is preferably thicker than that of the ferroelectric crystal 100 (the thinned ferroelectric crystal 100 after the etching process). For example, the final thickness (desired thickness) after the etching process of the electrode 110 is 100nm, the thickness of the adhesive 111 is 0.5 *µ* m, and the thickness of the substrate 112 is about 0.5mm.

As shown in FIG. 5, the second specific example of the substrate connecting process is to use a brazing material 113 to bond the electrode 111 and the substrate 120. At this time, as the electrode 110, a conductive base layer 112 is used which is highly adhesive. In addition, the conductive base layer 112 is also provided between the brazing material 113 and the substrate 120.

As the conductive base layer 112, it is preferable to use Al, Ti, and Cr, which are highly adhesive. By this, it is possible to bond the brazing material 113 and the conductive base layer 112, or the substrate 120 or the like, more certainly. Preferably, the conductive base layer 112 may be substantially 30nm thick; however, the present invention is not limited to this. It is enough if it is possible to bond the brazing material 113 and the conductive base layer 112, or the substrate 120 or the like. Moreover, the conductive base layer 112 can be also formed on the ferroelectric crystal 100 or the substrate 120, in the sputtering method or deposition method, as in the above-mentioned electrode 110.

Then, the conductive base layer 112 which is provided between the ferroelectric crystal 100 and the brazing material 113 becomes the electrode 110, and is used as the electrode in the etching process and the electrode of the dielectric recording medium.

Moreover, the brazing material 113 preferably includes Au and Sn, for example. These Au and Sn are accumulated, separately or in an alloy condition, on the connecting surface in a thin-film shape, by using the sputtering method or the like. Then, in order to bond the connecting surface, at least the connecting surface is heated to about 300 degrees Celsius, to thereby bond the conductive base layer 112 and the brazing material 113, and the brazing material 113 and the substrate 120 (i.e. the surface on which the conductive base layer 112 is formed).

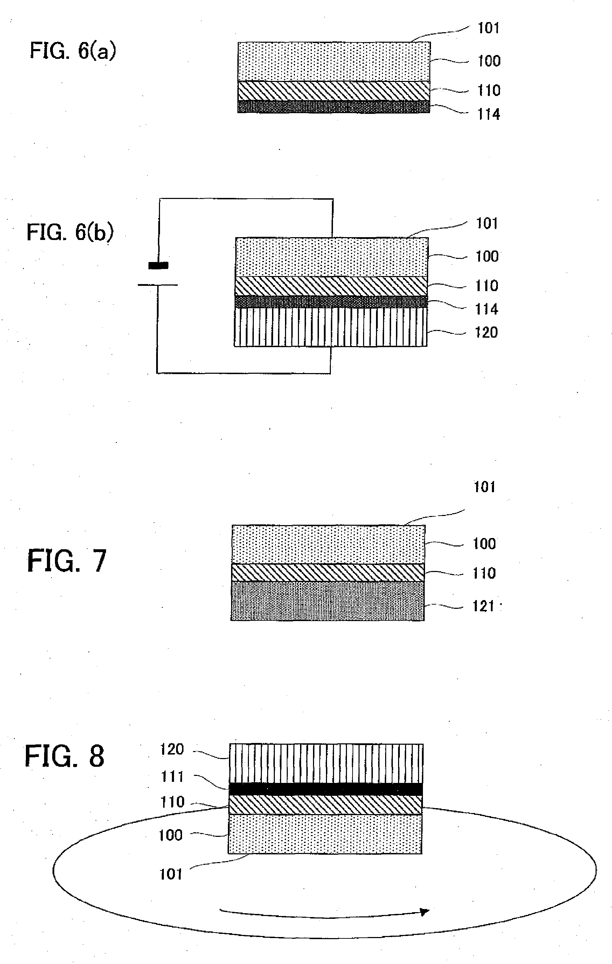

As shown in FIGs. 6, the third specific example is to bond the electrode 110 and the substrate 120 by anodic bonding. In this case, a glass film 114 is provided between the electrode 110 and the substrate 120.

Namely, as shown in FIG. 6(a), the glass film 114 is formed on a surface opposite to the connecting surface with the ferroelectric crystal 100, out of the electrode 110. As the glass film 114, it is preferable to use glass including alkali metal of Na, Li, or the like, such as pyrex (registered trademark) glass, for example.

Then, as shown in FIG. 6(b), after the substrate 120 is further closely attached to the glass film 114, it is heated to about 400 degrees Celsius, and a voltage of about 600V is applied between the glass film 114 and the substrate 120. At this time, the glass film 114 side is preferably set to a cathode. By this, alkali metal ion, such as Na ion and Li ion, is thermally diffused and displaced to the vicinity of a boundary surface of the substrate 120, to thereby make a connection which has a firm, uniform adhesive strength and which is highly reliable. Moreover, it is possible to firmly connect or bond the substrate 120 and the electrode 110, without an adhesive layer (i.e. the adhesive 111, the conductive base layer 112, and the brazing material 113) as shown in FIG. 4 and FIG. 5.

On the other hand, as shown in FIG. 7, the fourth specific example of the substrate connecting process is to use a glass substrate 121 including alkali metal, such as Na, to thereby directly perform the anodic bonding between the glass substrate 121 and the electrode 110. By this, without using the glass film 114, as in FIG. 6, it is possible to connect or bond the electrode 110 and the glass substrate 121, by the anodic bonding, more firmly, more uniformly, and more closely.

Incidentally, in the fourth specific example in which the glass substrate 121 is used for the anodic bonding, the electrode 110 preferably includes a metal material, such as Al, Cr, and Ti, for example.

Incidentally, in the anodic bonding as shown in FIG. 6 and FIG. 7, it is preferable to consider thermal expansion or the like of the ferroelectric crystal 100, the electrode 110, the glass film 114, the substrate 120, and the glass substrate 121 or the like, caused by the heating at about 400 degrees Celsius and the application of a voltage of about 600V In other words, it is preferable to consider the positioning of the substrate 120, or the like, for example, so as to appropriately connect or bond the substrate 120 and the glass film 114, or the glass substrate 121 and the electrode 110, even by the thermal expansion.

In addition, it is preferable to use the substrate 120 made of a material in which a difference in a coefficient of thermal expansion between the substrate 120 and the ferroelectric crystal 100 is 50% or less. More preferably, the substrate 120 and the ferroelectric crystal 100 may be made of the same material (i.e. the same ferroelectric material). By this, it is possible to prevent the damage, or the exfoliation or the like of the connecting surface between the substrate 120 and the ferroelectric crystal 100 caused by the temperature changes, as described above. This is a great advantage as the material of an information recording medium on which information is recorded and reproduced by the application of a voltage, as described later. In other words, even if the temperature of the ferroelectric crystal 100 increases and the ferroelectric crystal 100 expands due to the voltage application, since the substrate 120 also expands at the same rate or substantially the same rate, it is possible to prevent the damage, or the exfoliation or the like of the connecting surface. Thus, it is possible to appropriately use it as the information recording medium.

Moreover, not only the anodic bonding but also another direct connecting or bonding method (i.e. a method without using the adhesive 111, the brazing material 113, or the like) may be used. Alternatively, it is possible to use another method capable of appropriately connecting the electrode 110 and the substrate 120 (the glass substrate 121).

In addition, the substrate 120 and the glass substrate 121 in FIG. 4 to FIG. 7 are preferably thicker than the ferroelectric crystal 100. By this, it is possible to minimize a loss of the ferroelectric crystal 100. At the same time, the substrate 120 or the glass substrate 121 can be used as the support of the thinned ferroelectric crystal 100.

Moreover, if a ferroelectric substance made of the same material as that of the ferroelectric crystal 100 is used, a positional relationship of crystal orientation between the substrate 120 and the ferroelectric crystal 100 may be the same.

Next, FIG. 8 shows the "polishing process" in FIG. 1. As shown in FIG. 8, out of the ferroelectric crystal 100 after connecting the substrate 120, the surface on the side that the electrode 110 etc. are not formed (one surface side) is grinded or polished by surface grinding or a general rotary board or the like. The ferroelectric crystal 100 is thinned to about 10 *µ* m by the grinding or polishing. By this, it is possible to reduce a portion of the ferroelectric crystal 100 to be etched in the subsequent etching process, to thereby improve the efficiency of the thinning operation.

Incidentally, the parallelism of the surface 101 of the ferroelectric crystal 100 in the polishing process may be on the micrometer order. In other words, in the present production method, the final parallelism of the surface 101 of the ferroelectric crystal 100 is on the several tens nanometer order or nanometer order; however, it is not necessarily ensure this highly accurate parallelism at the stage of the polishing process. That is because the parallelism on the several tens nanometer order or nanometer order can be obtained in the subsequent etching process.

Incidentally, in the polishing process, it is preferable to remove an affected layer on the surface of the ferroelectric crystal 100 by the CMP (Chemical Mechanical Polishing) method after the mechanical polishing. By this, it is possible to reduce uneven etching in the subsequent etching process and increase a processing accuracy and processing speed.

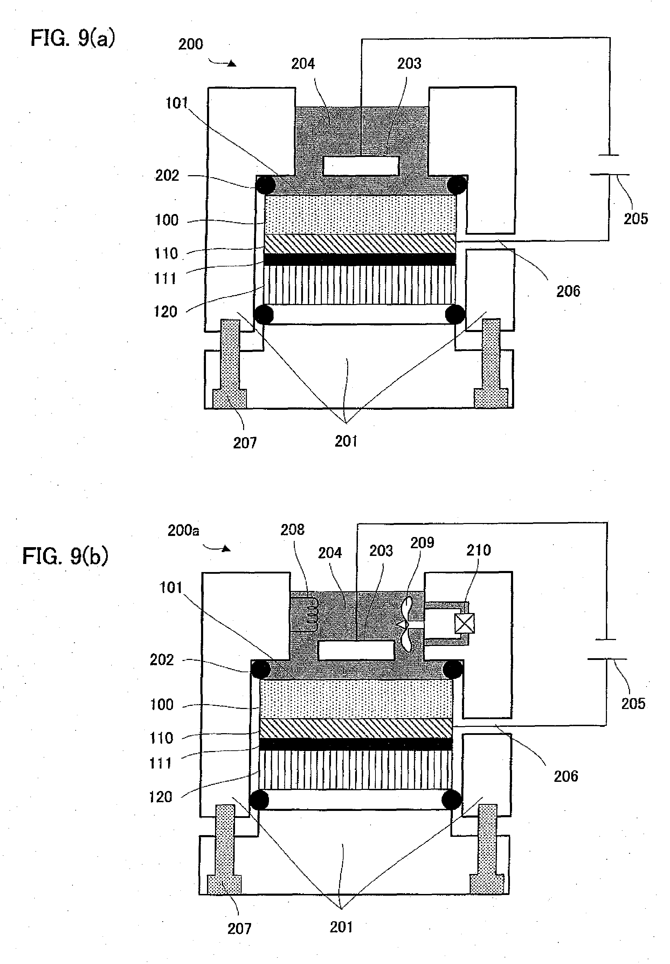

Next, FIGs. 9 to FIG. 11 show the "etching process" in FIG. 1.

At first, FIGs. 9 show a voltage-application etching apparatus used in the etching process. As shown in FIG. 9(a), a voltage-application etching apparatus 200 in the embodiment includes: an acid-resistant container 201; O rings 202; an electrode 203; an etching solution 204; a power supply 205; an electrode outgoing line 206; and fixtures 207. Then, the voltage-application etching apparatus 200 is used to perform wet etching with respect to the ferroelectric crystal 100.

The acid-resistant container 201 is an etching tank filled with the etching solution 204 and functions as a fixed unit for fixing and holding the ferroelectric crystal 100 and the like. The acid-resistant container 201 is directly exposed to the etching solution 204, so that it preferably includes an insulating, acid-resistant material, such as Teflon (registered trademark).

Then, so as to connect the electrode outgoing line 206 and the power supply 205, a path which the electrode outgoing line 206 can pass through is formed in the container 201.

The O ring 202 is one specific example of the "sealing device" of the present invention, and prevents the leakage of the etching solution 204, not to expose the etching solution 204 to the surface other than the surface 101 of the ferroelectric crystal 100. In addition, the O ring 202 electrically insulates the electrode 110 and the electrode 203. The O rings 202 are disposed along the periphery of the surface 101 to be closely attached to the periphery. Moreover, the O ring 202 is also directly exposed to the etching solution 204, so that it preferably includes an acid-resistant material.

The electrode 203 is one specific example of the "first connecting device" of the present invention, and is an electrode for applying a voltage to the surface 101 of the ferroelectric crystal 100 through the etching solution 204. The electrode 203 is directly exposed to the etching solution 204, so that it is preferably a metal electrode having acid-resistance, such as Pt.

Moreover, as the other electrode used for the voltage application for etching, it is possible to use the electrode 110 (or the conductive base layer 112) formed on the surface 102 of the ferroelectric crystal 100. Therefore, the voltage-application etching apparatus 200 is preferably constructed to connect the electrode 110 and the power supply 205. For example, as shown in FIG. 9(a), a leading line or the like (e.g. the electrode outgoing line 206) may be provided, from the electrode 110, for one portion of the acid-resistant container 201, and the leading line may be connected to the power supply 205.

The etching solution 204 includes a strong acid, such as hydrofluoric acid, and chemically erodes the surface 101 of the ferroelectric crystal 100, to thereby make the ferroelectric crystal 100 with the desired thickness. The etching tank constructed from the acid-resistant container 201 is filled with the etching solution 204.

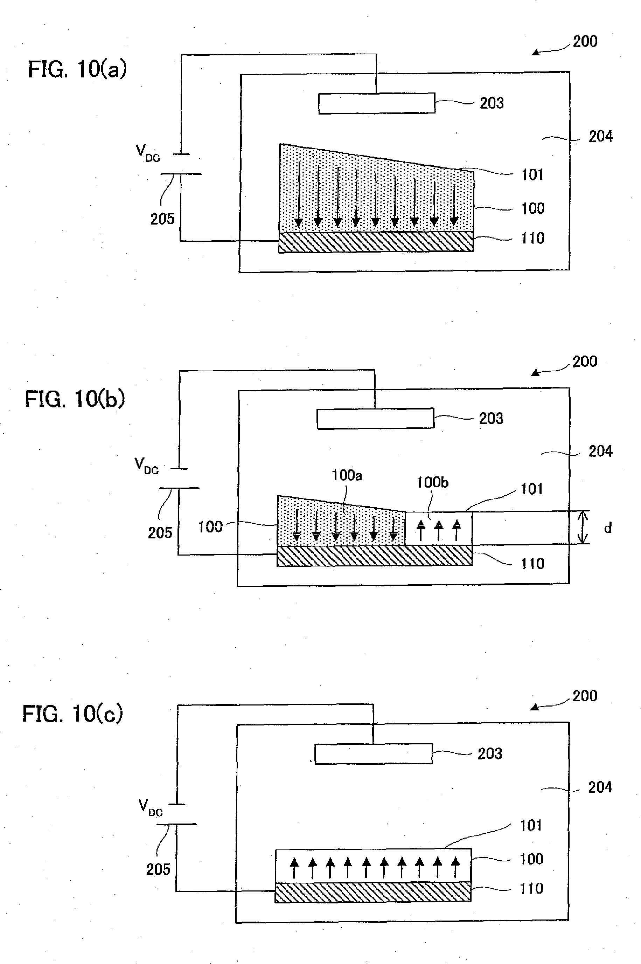

The power supply 205 applies a D.C. (Direct Current) voltage between the electrode 110 and the electrode 203 to thereby control the progress of the etching. Particularly in the embodiment, by setting a voltage supplied from the power supply 205 to a predetermined value in advance, it is possible to thin the ferroelectric crystal 100 to the desired thickness. A relationship of the numerical values will be discussed in detail later (refer to FIGs. 10).

Moreover, there may be provided a controlling device for setting or controlling various parameters (e.g. a voltage value, a current value, an application time length, polarity, a voltage waveform, etc.) of the power supply 205. The controlling device may be able to automatically control the parameters by a CPU or the like, or may be able to manually control the parameters from the exterior, such as a keyboard and an operation button.

The electrode outgoing line 206 is one specific example of the "second connecting device" of the present invention. It includes a contact member which is in contact with the electrode 110, a copper wire, or the like, for example, and applies a voltage supplied from the power supply 205, to the electrode 110 which is fixed in the container 201 and which is owned by the ferroelectric crystal 100 (including the substrate 120 and the like). If the ferroelectric crystal 100 is fixed in the container 201, the electrode outgoing line 206 preferably comes in contact with the electrode 205 at the same time of the fixing. By this, it is possible to apply a voltage to the electrode 205, from the power supply 205, relatively easily.

The fixture 207 is used to fix the acid-resistant container 207. Moreover, it is preferably constructed to set up the ferroelectric crystal 100 (including the substrate 120 and the like) to be etched, on the voltage-application etching apparatus 200, and take out the ferroelectric crystal 100 (including the substrate 120 and the like) after the etching, by releasing the fixing of the fixture 207 (or by unfixing).

Incidentally, as in a voltage-application etching apparatus 200a shown in FIG. 9(b), it may be further provided with a heater 208, a stirring device 209, and a filtration pump 21.0.

The heater 208 is used to heat the etching solution 204. The heater 208 preferably includes a conductive wire, such as a nichrome wire (wherein the conductive wire is disconnected from the etching solution 204 and is insulated (or isolated) from the etching solution having conductivity), and a power supply for supplying a current to the conductive wire, or the like. By this, it is possible to increase the progression rate of the etching, to thereby perform the etching, more efficiently.

The stirring device 209 can stir the etching solution 204, regularly or irregularly, in order to keep the concentration of the etching solution 204 uniform. For example, it preferably includes a motor and a propeller (or a stirring rod, etc.). By this, it is possible to uniformly promote the etching with respect to the surface (101).

The filtration pump 210 filtrates impurities which are free in the etching solution 204. It preferably includes a filtration filter, a pump which takes in the etching solution and opens after the filtration, or the like. By this, along with the progress of the etching, it is possible to remove the impurities which are free in the etching solution 204 and perform the effective etching with respect to the surface (101).

In addition, if the etching solution 204 is heated by the heater 208, the evaporation of the etching solution 204 is promoted. Therefore, there may be provided a refluxing device for refluxing the evaporated etching solution 204 to the etching tank again. The refluxing device preferably includes a vapor collecting device for collecting the evaporated etching solution 204 and a cooling / liquefying device for cooling and liquefying the collected vapor, or the like. Moreover, if the etching solution 204 is heated, there may be provided a temperature measuring device, such as a mercury thermometer and a thermocouple thermometer, which is used to control the temperature of the etching solution 204.

Next, FIGs. 10 show the procedure of the progress of the etching process. Incidentally, in the explanation of the procedure in FIGs. 10, it is assumed that Z-cut LiTaO₃ is used as the ferroelectric crystal 100. Moreover, in FIGs. 10, the voltage-application etching apparatus 200 shown in FIGs. 9 is simply illustrated. It is assumed that what is actually exposed to the etching solution 204 is only the surface 101 of the voltage-application etching apparatus 200 and that the electrode 110 and the electrode 203 are insulated.

As shown in FIG. 10(a), the polarization direction of the ferroelectric crystal 100, located in the etching solution 204, is set in advance to be in a direction directed from the surface 101 to the surface 102. As a result, the surface 101 exposed to the etching solution 204 is a minus surface. In LiTaO₃, the minus surface has a greater etching rate than a plus surface. Thus, the etching quickly proceeds on the surface 101.

Moreover, as shown in FIG. 10(a), in performing the etching process, the electrode 110 is connected to the anode side of the power supply 205, and the electrode 203 is connected to the cathode side of the power supply 205, to thereby drive the power supply 205. By this, a predetermined voltage is applied to the ferroelectric crystal 100 located in the etching solution 204, to thereby form an electric filed in the ferroelectric crystal 100. At this time, the polarization direction of the ferroelectric crystal 100 and the electric field formed in the ferroelectric crystal 100 have opposite polarity.

If the predetermined voltage applied to the ferroelectric crystal 100 is "V_{DC}", a coercive electric field of LiTaO₃ as being the ferroelectric crystal 100 is "E_{C}", and the thickness set on the ferroelectric crystal 100 is the "desired thickness d", V_{DC} = E_{C}×d. In other words, the voltage of the power supply 205 is set in order to apply the voltage V_{DC} to the ferroelectric crystal 100. Specifically, the coercive electric field Ec of LiTaO₃ is 22kV/mm, so that if the desired thickness d is 100nm, for example, then, a voltage V is 2.2V

At the start of the etching process, the etching has not proceeded yet. Thus, the thickness of the ferroelectric crystal 100 is the thickness immediately after the polishing process (e.g. 10 *µ* m). Therefore, at the current time point, even if the voltage V_{DC} of 2.2V is applied to the ferroelectric crystal 100, the polarization direction is not reversed.

As the etching proceeds, the ferroelectric crystal 100 becomes thinner. Then, as shown in FIG. 10(b), when the thickness of the ferroelectric crystal 100 reaches the desired thickness d, the polarization direction of the ferroelectric crystal 100 is reversed in a portion corresponding to the thickness d (i.e. a portion shown as 100b in FIG. 10(b)). This is because if the thickness of the ferroelectric crystal 100 reaches the desired thickness d, the electric field generated in the ferroelectric crystal 100 by the voltage V_{DC}, which is currently applied to the ferroelectric crystal 100, exceeds the coercive electric field of the ferroelectric crystal 100.

Here, as described above, in LiTaO₃, the plus surface has a much smaller etching rate than the minus surface. Thus, even if the etching solution 204 is a solution which can provide an appropriate etching rate with respect to the minus surface, it only provides an extremely small etching rate, nearly equal to being not etched, with respect to the plus surface. In other words, in practice, it can be said that the plus surface is not etched by the etching solution 204. Therefore, if the reverse of the polarization direction of the ferroelectric crystal 100 changes the portion of the surface 101 which has been the minus surface, to the plus surface 100b, the progress of the etching is practically stopped in the portion. As a result, the progress of the etching is stopped in the desired thickness d.

Therefore, if the coercive electric field Ec of the ferroelectric crystal 100 is learned in advance, if the desired thickness d is determined in advance, and if the voltage V_{DC} of the power supply 205 is set in advance on the basis of the above E_{C} and V_{DC}, it is possible to etch the ferroelectric crystal 100, highly accurately, until reaching the desired thickness d.

Even some dispersion or variation of the progress of the etching may cause a time difference for the ferroelectric crystal 100 to reach the desired thickness d. However, for example, the progress of the etching is stopped in the portion 100b which has already reached the desired thickness d, the portion 100b maintains the desired thickness d while the etching progresses in a portion 100a in which the desired thickness is not reached.

Before long, the thickness of the entire portion of the ferroelectric crystal 100 becomes the desired thickness d, and the progress of the etching is completely stopped. As a result, the ferroelectric crystal 100 has the thickness d over the entire surface, and the entire surface becomes flat or even.

As described above, according to the production method in the embodiment, even in the case of the ferroelectric crystal wafer having a large area, it is possible to produce the ferroelectric thin film which is extremely thin and which has a uniform thickness, by appropriately adjusting or controlling a voltage in the etching. Then, by using the ferroelectric thin film produced in this manner as a material, it is possible to mass-produce the ferroelectric recording medium.

Incidentally, since the etching solution 204 or the like has a slow progression rate of the etching (i.e. a small etching rate), it is preferable to heat the etching solution 204 to about 80 degrees Celsius, for example, by using the heater 208.

Incidentally, in FIGs. 10, LiTaO₃ is used for the explanation; however, even in a ferroelectric crystal other than LiTaO₃ (e.g. the above-mentioned LiNbO₃, etc.), it is possible to thin it to the desired thickness if it is a ferroelectric crystal having a difference in the etching rate, due to the difference of plus (positive) and minus (negative) in the polarization.

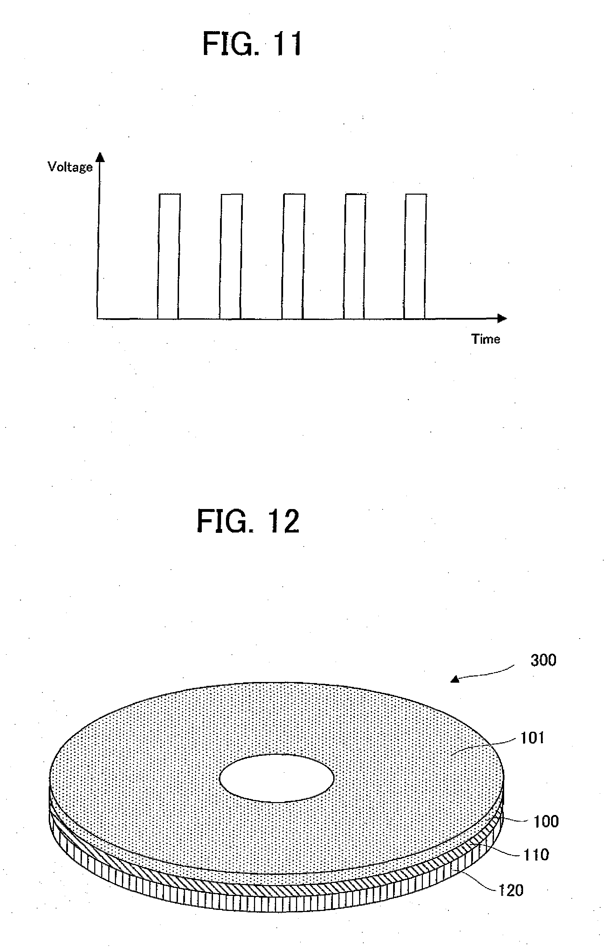

Incidentally, the power supply 205 may supply not only a DC voltage but also a pulse voltage, as shown in FIG. 11. In the case of the supply of the pulse voltage, it is possible to improve the control of the etching (e.g. fine processability, etching speed, etc.) by that the above-mentioned controlling device adjusts or controls the strength of the pulse voltage, a pulse width, or a duty ratio, or the like, as occasion demands.

In particular, if the DC voltage is applied, there is a possibility to increase the etching rate of a surface which is originally difficult to be etched (i.e. a surface having a plus (positive) polarization direction in the case of the ferroelectric crystal 100 as being LiTaO₃) because of an electrochemical action on the ferroelectric crystal 100. However, by applying the pulse voltage as shown in FIG. 11, it is possible to apply a voltage appropriate enough not to produce the electrochemical action, and it is possible to perform more appropriate etching.

Incidentally, even in the case where the pulse voltage is supplied, the controlling device may be provided, as in the case where above-mentioned DC voltage is supplied. For example, the controlling device may be able to control various parameters of the power supply 205 (e.g. the strength of the pulse voltage, a pulse width, or a duty ratio, or the like in addition to the above-mentioned various parameters).

Moreover, various apparatuses used in the ferroelectric thin-film production method in the above-mentioned embodiment can be combined to be a thin-film producing apparatus. In other words, a sputtering apparatus, an anodic bonding apparatus, and a voltage-application etching apparatus are combined to be the thin-film producing apparatus, and by using the thin-film producing apparatus, it is possible to produce a thin film including a ferroelectric crystal having the above-mentioned various benefits.

Next, an example is given in the case where a ferroelectric crystal thin-film substrate produced in the ferroelectric thin-film production method in the above-mentioned embodiment is applied to the ferroelectric recording medium.

As shown in FIG. 12, the ferroelectric crystal thin-film substrate produced in the ferroelectric thin-film production method in the embodiment can be used as a disc-shaped dielectric recording medium 300, for example. Namely, the ferroelectric crystal 100 is a recording layer, and the electrode 110 is used as the electrode of the dielectric recording medium 300 as it is, and the substrate 120 can be used as the support of the dielectric recording medium 300 as it is. Incidentally, in FIG. 12, the adhesive 111 or the like is omitted. Moreover, the ferroelectric crystal thin-film substrate having a large area and produced in the ferroelectric thin-film production method in the embodiment can be cut into a rectangle and used as a recording medium for x-y scan recording / reproduction using a multi-probe.

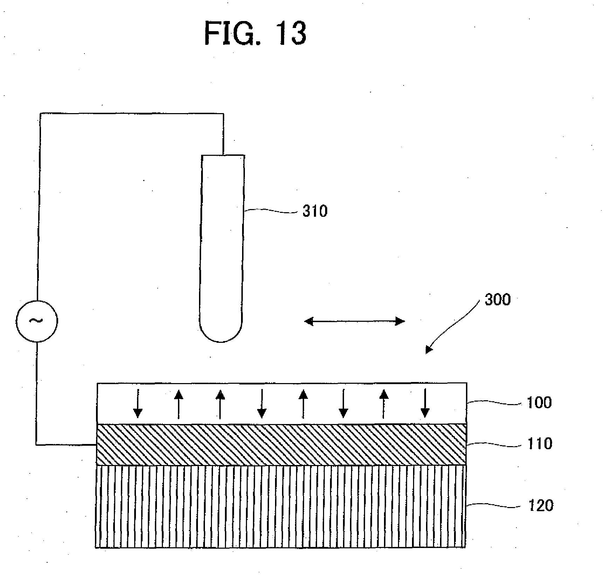

As shown in FIG. 13, the information is recorded by the local polarization direction of the ferroelectric crystal 100 of the ferroelectric recording medium 300. For example, if the data bit of the information is "1", it is recorded as an upward polarization direction. If the data bit of the information is "0", it is recorded as a downward polarization direction. The information is recorded by applying an electric filed which exceeds the actual coercive electric field onto the ferroelectric crystal 100. Specifically, a voltage pulse signal corresponding to the information (data bit row) is applied between a probe 310 and the electrode 110 so as to form an electric filed which exceeds the actual coercive electric field on the ferroelectric crystal 100 only if the pulse is at high level. Then, the application of the voltage pulse signal is performed while a positional relationship between the probe 310 and the electrode 110 is changed in an arrow -pointing direction in FIG. 13. By this, the polarization direction is reversed only in the portion where the electric field which exceeds the coercive electric field is formed, which causes the information to be recorded into the ferroelectric crystal 100.

In the ferroelectric crystal 100 produced in the above-mentioned production method, the polarization directions are all oriented in the same direction, immediately after the production. Then, the polarization directions are perpendicular to the recording surface. Therefore, the ferroelectric crystal 100 can be immediately used as the ferroelectric recording medium 300 into which the information is recorded by the reverse of the polarization direction. As a result, there is an advantage that it is unnecessary to perform a format operation of align or uniform the polarization directions in using the dielectric recording medium 300.

Then, the ferroelectric crystal 100 produced in the above-mentioned production method is thin, about 100nm in thickness. Therefore, it is possible to reduce a voltage to reverse the polarization direction of the ferroelectric crystal 100; namely, the voltage of the recording voltage pulse to record the information, and thus it is possible to reduce the power consumption of the recording apparatus.

Moreover, the ferroelectric crystal 100 produced in the above-mentioned production method is uniform in thickness. Therefore, it is possible to provide a constant voltage to reverse the polarization direction of the ferroelectric crystal 100; namely, the constant voltage of the recording voltage pulse to record the information.

Incidentally, the drawings used for the explanation of the embodiments of the present invention embodies the constitutional elements or the like of the ferroelectric thin-film production method, the voltage-application etching apparatus, and the thin film of the present invention, only for the purpose of explaining technical ideas thereof. The shape, size, position, connection relationship, and the like of the various constitutional elements or the like are not limited to the drawings.

In the present invention, various changes may be made, if desired, without departing from the essence or spirit of the invention which can be read from the claims and the entire specification. The constitutional elements or the like of the ferroelectric thin-film production method, the voltage-application etching apparatus, and the thin film, all of which involves such changes, are also intended to be within the technical scope of the present invention.

### Industrial Applicability

The present invention can be applied to the ferroelectric thin-film production method, the voltage-application etching apparatus used in the ferroelectric thin-film production method, and the ferroelectric crystal thin-film substrate including the thin film produced in the ferroelectric thin-film production method.

## Claims

1. A ferroelectric thin-film production method comprising:
an etching process of dipping one surface in an etching solution to thereby etch the one surface, with respect to a ferroelectric crystal which has the one surface and another surface that face each other and in which an etching rate of the one surface is greater than an etching rate of the another surface in such a condition that polarization directions are oriented in one direction; and
a voltage applying process of applying a predetermined voltage between the one surface and the another surface.

2. The ferroelectric thin-film production method according to claim 1,
wherein the ferroelectric crystal is a single crystal wafer of a ferroelectric substance.

3. The ferroelectric thin-film production method according to claim 1,
wherein the ferroelectric crystal includes at least one of LiNbₓTa₁₋ₓO₃ (0≦x≦ 1), M: LiNbₓTa₁₋ₓO₃ (0≦x≦1, M is a doping material), and K₃Li₂₋ₓ(Nb_{1-y}Ta_{y}) ₅₊ₓO₁₅₊₂ₓ.

4. The ferroelectric thin-film production method according to claim 1,
wherein if a desired thickness of the ferroelectric crystal is d and a coercive electric field of the ferroelectric crystal is Ec, the predetermined voltage is Ec × d.

5. The ferroelectric thin-film production method according to claim 1,
wherein the voltage is a direct current voltage.

6. The ferroelectric thin-film production method according to claim 1,
wherein the voltage is a pulse voltage.

7. The ferroelectric thin-film production method according to claim 4,
wherein the desired thickness is less than 1 *µ* m.

8. The ferroelectric thin-film production method according to claim 1,
wherein the etching solution includes hydrofluoric acid.

9. The ferroelectric thin-film production method according to claim 1,
wherein the etching solution has conductivity.

10. The ferroelectric thin-film production method according to claim 1,
wherein said etching process includes a heating process of heating the etching solution.

11. The ferroelectric thin-film production method according to claim 1,
wherein said etching process includes a stirring process of stirring the etching solution.

12. The ferroelectric thin-film production method according to claim 1,
wherein said etching process includes a filtrating process of filtrating the etching solution.

13. The ferroelectric thin-film production method according to claim 1,
wherein the ferroelectric thin-film production method comprises:
an electrode forming process of forming an electrode in a film shape on the another surface;
a substrate connecting process of connecting the electrode and a substrate; and
a polishing process of polishing the one surface of the ferroelectric crystal, and
said etching process and said voltage applying process are performed after said electrode forming process, said substrate connecting process and said polishing process.

14. The ferroelectric thin-film production method according to claim 13,
wherein the substrate has a difference in a coefficient of thermal expansion of 50% or less, as compared to the ferroelectric crystal.

15. The ferroelectric thin-film production method according to claim 13,
wherein the substrate includes a same material as that of the ferroelectric crystal.

16. The ferroelectric thin-film production method according to claim 13,
wherein the electrode and the substrate are connected by providing an adhesive layer therebetween, in said substrate connecting process.

17. The ferroelectric thin-film production method according to claim 16,
wherein a conductive base layer which is highly adhesive is provided at least one of between the adhesive layer and the electrode, and between the adhesive layer and the substrate, in said substrate connecting process.

18. The ferroelectric thin-film production method according to claim 13,
wherein the substrate is a glass substrate, and the electrode and the substrate are directly connected by anodic bonding, in said substrate connecting process.

19. The ferroelectric thin-film production method according to claim 13,
wherein a glass film is provided between the electrode and the substrate, and the electrode and the substrate are connected by anodic bonding, in said substrate connecting process.

20. The ferroelectric thin-film production method according to claim 13, wherein a smoothing process is performed to the one surface after the one surface is polished.

21. A voltage-application etching apparatus used in said etching process and said voltage applying process in the ferroelectric thin-film production method according to claim 1,
said voltage-application etching apparatus comprising:
a container to dip the one surface in the etching solution;
a sealing device for sealing a portion other than the one surface from the etching solution;
a power supply for applying the predetermined voltage between the one surface and the another surface;
a first connecting device for electrically connecting one output terminal of said power supply with the one surface; and
a second connecting device for electrically connecting another output terminal of said power supply with the another surface.

22. The voltage-application etching apparatus according to claim 21, wherein said sealing device is an acid-resistant O ring which is pressed onto a periphery portion on the one surface or an outer edge of the one surface.

23. The voltage-application etching apparatus according to claim 21, further comprising a heating device for heating the etching solution.

24. The voltage-application etching apparatus according to claim 21, further comprising a stirring device for stirring the etching solution.

25. The voltage-application etching apparatus according to claim 21, further comprising a filtrating device for filtrating the etching solution.

26. A ferroelectric crystal thin-film substrate comprising:
a substrate;
an electrode formed on the substrate; and
a ferroelectric crystal which is formed on the electrode and which is less than 1 *µ* m in thickness, wherein
an area size of an entire surface of the substrate is equal to or greater than 10mm².

27. The ferroelectric crystal thin-film substrate according to claim 26, wherein the substrate is a glass substrate, and the substrate and the electrode are directly connected by anodic bonding.

28. The ferroelectric crystal thin-film substrate according to claim 26, wherein in the ferroelectric crystal, polarization directions are perpendicular to the surface and oriented in a same direction.

29. A ferroelectric crystal wafer comprising:
a substrate;
an electrode formed on the substrate; and
a ferroelectric crystal which is formed on the electrode and which is less than 1 *µ* m in thickness.

30. The ferroelectric crystal wafer according to claim 29, wherein the substrate is a glass substrate, and the substrate and the electrode are directly connected by anodic bonding.

31. The ferroelectric crystal wafer according to claim 29, wherein in the ferroelectric crystal, polarization directions are perpendicular to the surface and oriented in a same direction.
